# EUROPEAN PATENT SPECIFICATION

(11) **EP 2 690 784 B1**
(45) Date of publication and mention of the grant of the patent: **26.12.2018**
(21) Application number: 13176489.6
(22) Date of filing: 15.07.2013
(51) Int. Cl.: H03K 17/082, G01R 31/317, H02H 3/04, H02H 3/08

(54) **Self-test of over-current fault detection**
Selbsttest einer Überstromfehlererkennung
Test automatique de détection d'une défaillance de surintensité

(30) Priority: 26.07.2012 US 201213559128
(43) Date of publication of application: 29.01.2014
(73) Proprietor: Hamilton Sundstrand Corporation, Windsor Locks, CT 06096-1010 (US)
(72) Inventor: Saloio, James, Ludlow, MA Massachusetts 01056 (US); Gosse, James A., Storrs, CT Connecticut 06268 (US)
(74) Representative: Dehns

(56) References cited:
- EP-A2- 1 763 137
- US-A1- 2006 290 333
- US-A1- 2008 150 369
- US-A1- 2012 098 517

## Description

### BACKGROUND

The current invention is related to over-current fault detection, and in particular to a system and method for testing over-current fault detection in the field.

Excitation circuits are often used to control the application of power to a load. These circuits include switches which can be enabled or disabled to provide or cut off power to a load respectively. Excitation circuits, especially in critical systems such as those for jet engines, need to have over-current fault detection circuitry. In critical systems with multiple loads, it is also important to be able to isolate the specific fault from affecting the remaining system by switching off the excitation to only the individual faulted load.

An over-current fault is a fault in which there is an excess current flowing through a conductor. This excess current can be created by, among other things, a short-circuit fault in the load. Over-currents create excessive heat, which in turn creates a risk of fire or other damage to equipment. Therefore, it is necessary to detect over-current faults so that they can be handled and damage to the system can be prevented.

In the past, over-current fault handling has been tested by applying an external fault to the system. Because of this, the over-current fault handling circuitry could not be tested in the field. Testing could only occur during times when an external fault could be applied to the system. Therefore, if any problems arose in the over-current detection circuitry during normal system operation, those problems would not be detected and thus, any over-current faults would go unregulated. Further, test equipment used to apply an external fault increases overhead and production test costs.

US 2012/098517 describes a high-side switch control circuit that includes over-current detection during operation of a high-side switch. The over-current detection includes a resistive element arid a comparator. An over-current condition is indicated if the voltage of the resistive element exceeds a threshold value. In EP 1763137, a system is disclosed for automatically interrupting current flow in the event of a fault condition.

### SUMMARY

A system and method for testing over-current fault detection according to the invention are defined in the appended claims.

### BRIEF DESCRIPTION OF THE DRAWINGS

FIG. 1 is a block diagram illustrating an example useful for understanding the present invention.
FIG. 2 is a flow chart illustrating a method of testing over-circuit detection circuitry based upon an example useful for understanding the present invention.
FIGS. 3A-3D are charts illustrating a voltage of a capacitor, a high-side switch enable signal, a low-side switch enable signal, and an over-current signal over time according to an example useful for understanding the present invention.
FIG. 4 is a flow chart illustrating a method of enabling a high-side switch according to an example useful for understanding the present invention.
FIG. 5 is a flow chart illustrating an alternate method of enabling a high-side switch according to an example useful for understanding the present invention.
FIG. 6 is a block diagram illustrating an a system for testing over-current fault detection according to an embodiment of the present invention.
FIGS. 7A and 7B are charts illustrating a voltage across capacitor 20 compared to a reference voltage (V_{reference}), and a current through resistor 18 compared to an over-current trip reference, respectively, according to an embodiment of the present invention.
FIG. 8 is a flow chart illustrating a method of testing over-current fault detection according to a separate embodiment of the present invention.

### DETAILED DESCRIPTION

The present invention describes an excitation circuit with over-current fault detection that provides an ability to self-test the over-current fault detection in the field. In particular, the system includes high-side and low-side switches, a microcontroller, a difference amplifier, a comparator, a resistor, and a capacitor. The microcontroller contains logic to detect an over-current fault and control the high-side and low-side switches. Together, the resistor and capacitor act as a filtered current monitor during normal operation. During the over-current self test, the initial charging of the capacitor is used to force an over-current test condition.

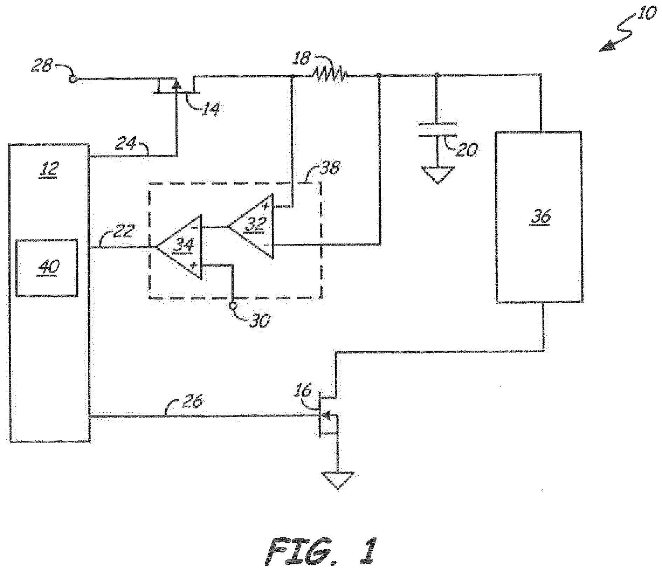

FIG. 1 is a block diagram illustrating an example
of excitation system 10. System 10 includes microcontroller 12, high-side switch 14, low-side switch 16, resistor 18, capacitor 20, over-current line 22, high-side switch enable line 24, low-side switch enable line 26, voltage terminal 28, reference voltage 30, difference amplifier 32, comparator 34, external load 36, monitor circuit 38, and transient filter 40. High-side switch 14 and low-side switch 16 are illustrated as metal-oxide semiconductor field effect transistors (MOSFETs), but may be implemented using any other known switching technology. Microcontroller 12 may be implemented using a field programmable gate array (FPGA).

During normal system operation, high-side switch 14 and low-side switch 16 are used to excite external load 36. High-side switch 14 is first enabled to provide a voltage to external load 36. Low-side switch 16 is then enabled to excite external load 36 by providing a path to ground. Microcontroller 12 is programmed with digital logic to control the enablement of high-side switch 14 and low-side switch 16. Microcontroller 12 may also be connected to receive instructions from a microprocessor such as a digital signal processor (DSP).

Monitor circuit 38, microcontroller 12, and resistor 18 are used to detect an over-current fault during operation of system 10. Monitor circuit 38 includes difference amplifier 32 and comparator 34 which are used to monitor current through resistor 18. While illustrated using a difference amplifier and a comparator, monitor circuit 38 may be designed using any number of implementations capable of monitoring current through resistor 18 known in the art. Voltages on each side of resistor 18 are input into difference amplifier 32. The output of difference amplifier 32 is input into comparator 34 and compared to a reference voltage 30. Reference voltage 30 may be obtained from a supply voltage and set using, for example, a resistor voltage divider circuit. Reference voltage 30 is chosen such that it is less than the output of difference amplifier 32 if there is a larger than expected current through resistor 18. Because reference voltage 30 is input into comparator 34 at the positive terminal, the output of comparator 34 will be active-low, meaning it will provide a logic zero to indicate an over-current condition. Alternate examples may be implemented such that the output of comparator 34 will be active-high. This output, on over-current line 22, is input into microcontroller 12.

Microcontroller 12 includes transient filter 40 to handle any temporary spikes in current caused by, for example, a lighting strike on an aircraft. This way, systems do not need to be interrupted due to a false over-current detection for temporary spikes in current that can be expected during normal system operation. Because of this, microcontroller 12 waits a predetermined over-current fault time (T_{over-current}), such as 55 microseconds, before indicating an over-current fault condition. If the signal on over-current line 22 indicates an over-current condition for greater than T_{over-current}, microcontroller 12 disables high-side switch 14 and indicates a detected over-current fault. This indication may be accomplished by setting a software readable bit, illuminating a light-emitting diode (LED), or providing any other type of indication of the fault. In separate examples, microcontroller 12 may also disable low-side switch 16 immediately upon detection of an over-current fault.

Capacitor 20 is included in order to allow excitation system 10 to self-test the functionality of the over-current fault detection circuitry prior to normal system operation. To initiate a test, capacitor 20 must be discharged. Low-side switch 16 may be enabled for a short period of time in order to discharge capacitor 20. Upon enablement of high-side switch 14, capacitor 20 will charge. During charge-up, capacitor 20 initially acts as a short to ground which creates a large in-rush current through resistor 18 that exceeds the expected steady-state current drawn by external load 36 during normal operation. The circuit values of resistor 18 and capacitor 20, and the scaling of monitor circuit 38 can be selected to ensure that an over-current condition is created through resistor 18 during charge-up of capacitor 20.

A test of the functionality of the over-current fault detection circuitry comprises enabling high-side switch 14 for a time greater than T_{over-current} when capacitor 20 is not yet charged. A successful test occurs if microcontroller 12 indicates an over-current fault during this time period. Following a successful test, high-side switch 14 may be enabled indefinitely, as described below, for normal system operation. If a fault is not detected, system 10 may disable, and then re-enable high switch 14 again for a time greater than T_{over-current}. This process may be repeated a predetermined number of times. If an over-current fault has not been indicated after the process has been repeated the predetermined number of times, then the test has failed and proper action can be taken, such as alerting a technician so that the circuit may be repaired or replaced.

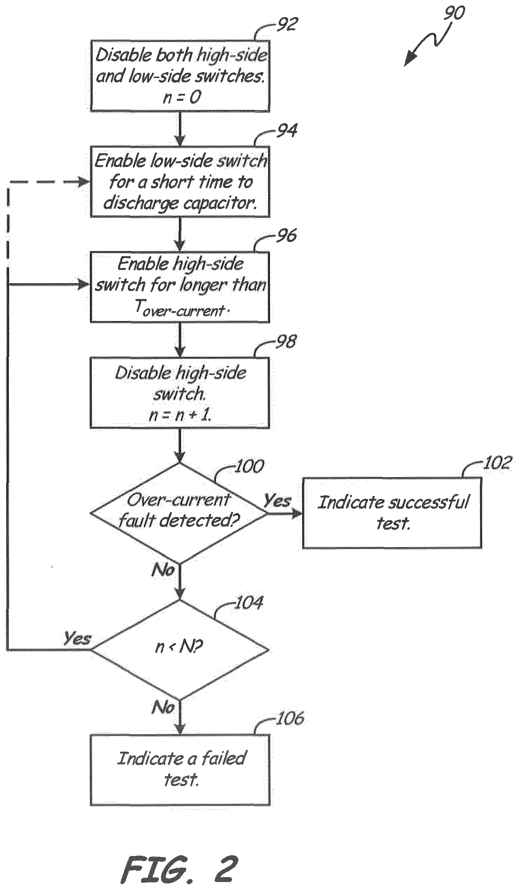

FIG. 2 is a flowchart illustrating a method 90 for testing the functionality of the over-current fault detection of excitation system 10 according to an example useful for understanding the present invention. At step 92, both high-side switch 14 and low-side switch 16 are disabled. At step 94, low-side switch 16 is enabled for a short period of time to discharge capacitor 20. In examples for which it is known that capacitor 20 is already discharged, step 94 may be omitted. At step 96, high-side switch 14 is enabled for a time greater than T_{over-current}, such as a time approximately 30% greater than T_{over-current}. At step 98, high-side switch 14 is disabled. At step 100, it is determined if microcontroller 12 has detected an over-current fault. If an over-current fault has been indicated, method 90 proceeds to step 102. If an over-current fault has not been indicated, method 90 proceeds to step 104. At step 102, a successful test is indicated. At step 104, if steps 96 and 98 have been completed greater than a predetermined number of retry attempts (N), then method 90 proceeds to step 106 and microcontroller 12 indicates that the test has failed. Otherwise, method 90 returns to step 96. Optionally, as illustrated by the dashed line in FIG. 2, method 90 can return to step 94 to ensure capacitor 20 is fully discharged for each of the predetermined number of retry attempts (N). The predetermined number of retry attempts (N) may be any number determined to be sufficient to indicate a failed test.

Capacitor 20 has no charge when initially enabling high-side switch 14 for normal system operation. Normal system operation comprises keeping high-side switch 14 enabled indefinitely such that low-side switch 16 may be enabled and disabled to excite external load 36 as required by system 10. Because enabling high-side switch 14 creates an over-current condition when capacitor 20 is not charged, the signal on high-side switch enable line 24 must be modulated on and off when enabling high-side switch 14 for normal system operation. Each high-side switch enable pulse must be less than T_{over-current} so as not to create a false over-current fault. The signal on high-side switch enable line 24 is pulsed until capacitor 20 is charged to a voltage such that enablement of high-side switch 14 for greater than T_{over-current} will not cause an over-current fault condition. High-side switch 14 then remains enabled for the rest of normal system operation so that capacitor 20 remains charged and external load 36 may be excited by enabling low-side switch 16 as necessary.

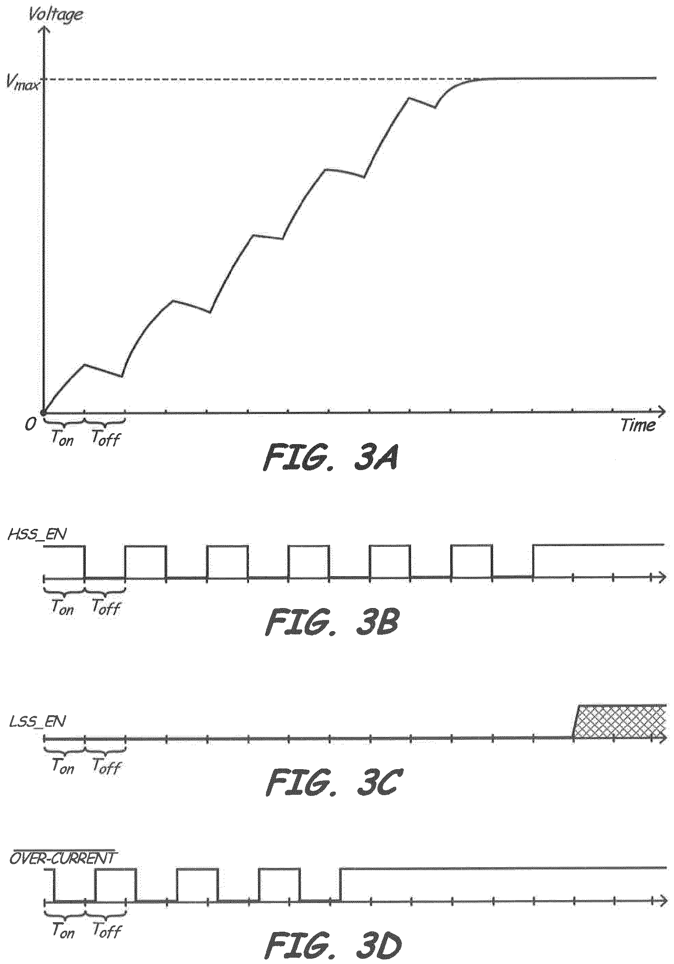

FIG. 3A is a chart illustrating the voltage of capacitor 20 during enablement of high-side switch 14 for normal system operation. The y-axis is the value of the voltage of capacitor 20, and the x-axis is time. Vₘₐₓ is a value roughly equal to the input voltage on voltage terminal 28. Tₒₙ is the amount of time the high-side switch is enabled for each pulse. T_{off} is the amount of time the high-side switch is disabled for each pulse. In the present example, Tₒₙ= T_{off}. The value of Tₒₙ may be, for example, 20 microseconds. Tₒₙ must be less than T_{over-current} so as not to trigger an over-current fault.

FIG. 3B is a chart illustrating a value on high-side switch enable line 24 during enablement of high-side switch 14 for normal system operation. High-side switch 14 may be pulsed a predetermined number of times such that it is guaranteed that capacitor 20 will be fully charged. Although illustrated as 6 pulses, this predetermined number of pulses is determined based upon the voltage of voltage terminal 28, the resistance of resistor 18, the capacitance of capacitor 20, and the internal resistance of high-side switch 14. After this predetermined number of times, high-side switch 14 may be enabled indefinitely for normal system operation.

FIG. 3C is a chart illustrating the value on low-side switch enable line 26 during enablement of high-side switch 14 for normal system operation. Low-side switch enable line 26 is held low to disable low-side switch 16 until capacitor 20 is fully charged. Following enablement of high-side switch 14 for normal system operation, low-side switch 16 may be enabled and disabled at any time to excite external load 36 as required by system 10. Low-side switch 16 is enabled by setting the signal on low-side switch enable line 26 high.

FIG. 3D is a chart illustrating the value on over-current line 22 during enablement of high-side switch 14 for normal system operation. When high-side switch 14 is enabled, as depicted in FIG. 3B, the value on over-current line 22 goes low to indicate an over-current condition due to the in-rush current through capacitor 20. When high-side switch 14 is disabled, the value on over-current line 22 goes high to indicate no over-current condition is present. Once capacitor 20 is charged to a high-enough value, the value on over-current line 22 remains high, indicating that no over-current condition is present due to in-rush current through capacitor 20.

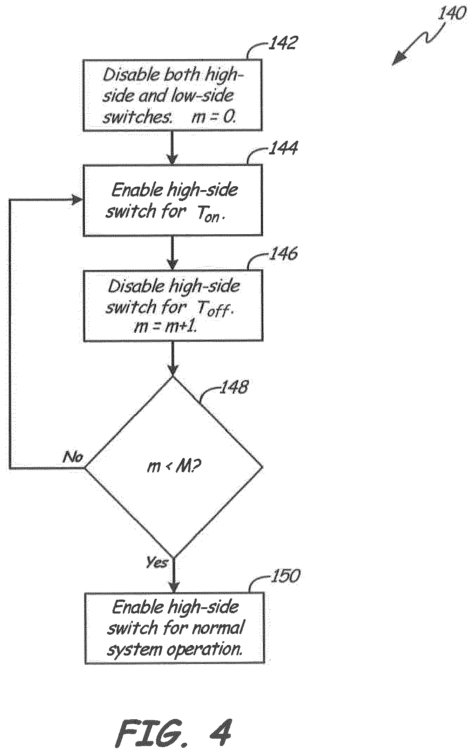

FIG. 4 is a flowchart illustrating a method 140 of enabling high-side switch 14 for normal system operation. At step 142, high-side switch 14 and low-side switch 16 are disabled. At step 144, high-side switch 14 is enabled for Tₒₙ. At step 146, high-side switch 14 is disabled for T_{off}. At step 148, it is determined if high-side switch 14 has been pulsed a predetermined number of times (M) that ensures that capacitor 20 is sufficiently charged based on the given circuit characteristics of high-side switch 14, resistor 18, and capacitor 20. If high-side switch 14 has been pulsed the predetermined number of times (M) then method 140 proceeds to step 150 and high-side switch 14 may be enabled indefinitely for normal system operation. If high-side switch 14 has not been pulsed the predetermined number of times (M), method 140 returns to step 144. In the present example, Tₒₙ is equal to T_{off}. It may be advantageous in some systems to set the high-side switch disable time longer, for example, than the high-side switch enable time in order to further control or limit the average current into capacitor 20 and to limit the corresponding average circuitry power during the entirety of method 140.

Alternatively, the signal on over-current line 22 may be used as feedback to determine when high-side switch 14 may be enabled indefinitely for normal system operation. Once capacitor 20 is charged to a high enough level, an over-current condition will no longer be seen on over-current line 22 due to in-rush current through capacitor 20. Therefore, while pulsing the enable signal for high-side switch 14, microcontroller 12 may monitor the input from over-current line 22 to determine when capacitor 20 has been charged to a level such that the in-rush current will not create an over-current condition. If the signal on over-current line 22 is active-high when high-side switch 14 is enabled, microcontroller 12 will know that high-side switch 14 may be enabled indefinitely for normal system operation. Using over-current line 22 as feedback to determine when high-side switch 14 may be enabled indefinitely is useful in applications where load 36 or the conductor connecting power to load 36 has an unknown or varying capacitive element that adds to capacitor 20 and, therefore, makes it impractical to determine a pre-determined number of pulses as used by method 140.

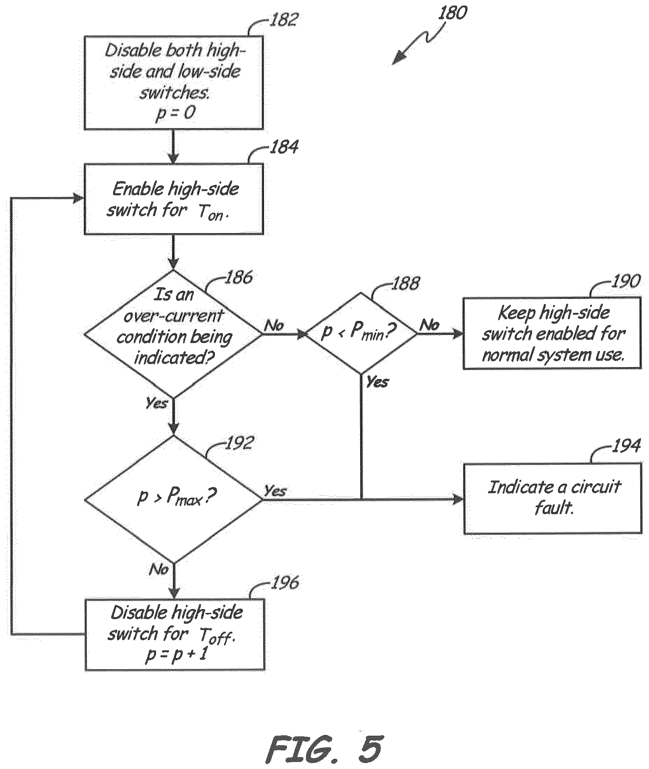

FIG. 5 is a flowchart illustrating an alternate method 180 of enabling a high-side switch for normal system operation according to an example useful for understanding the present invention. At step 182, high-side switch 14 and low-side switch 16 are disabled. Microcontroller 12 tracks the number of times high-side switch 14 has been enabled (p). At step 184, high-side switch 14 is enabled for Tₒₙ. At step 186, it is determined if the signal on over-current line 22 has transitioned high. If it has, method 180 proceeds to step 188. If it has not, method 180 proceeds to step 192. At step 188, it is determined if the number of times high-side switch 14 has been enabled (p) is less than a predefined minimum number of pulses it should take to charge capacitor 20 (Pₘᵢₙ). If it is, method 180 proceeds to step 194 and indicates a circuit fault. If it is not, method 180 proceeds to step 190 and enables high-side switch 14 for normal system operation. At step 192, it is determined if the number of times high-side switch 14 has been enabled (p) is greater than a predefined maximum number of pulses it should take to charge capacitor 20 (Pₘₐₓ). If it is, method 180 proceeds to step 194 and indicates a circuit fault. If it is not, method 180 proceeds to step 196. At step 196 high-side switch 14 is disabled for T_{off} in order to not create a false over-current fault. Method 180 then returns to step 184. In the present example, Tₒₙ is equal to T_{off}. It may be advantageous in some systems to set the high-side switch disable time longer, for example, than the high-side switch enable time in order to further control or limit the average current into capacitor 20 and to limit the corresponding average circuitry power for the entirety of method 180.

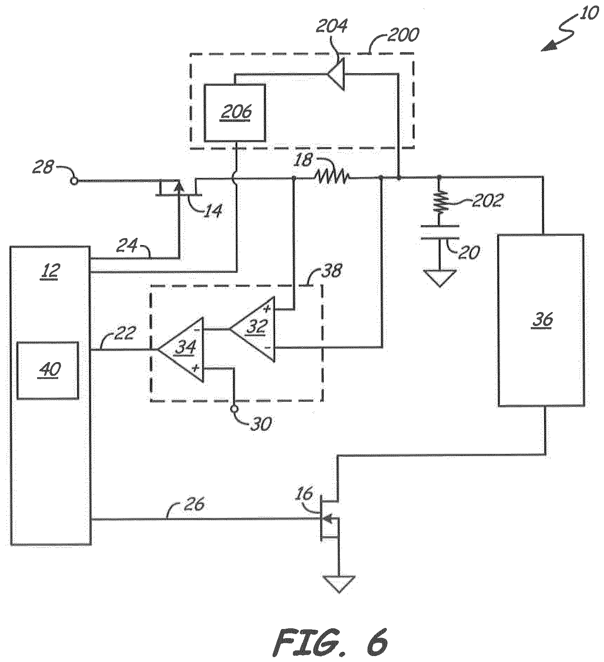

FIG. 6 is a block diagram illustrating system 10 for testing over-current detection according to a separate embodiment of the present invention. In the present embodiment, system 10 also includes a second monitor circuit 200 and current limiting resistor 202. Monitor circuit 200 includes scaling circuit 204, and analog-to-digital converter/comparator module 206. Current limiting resistor 202 is optional and is utilized to limit the in-rush current to capacitor 20. Scaling circuit 204 is any circuit known in the art for scaling a voltage up or down and is used to scale the voltage across capacitor 20 to a sufficient level for comparison with a reference voltage. An input to scaling circuit 204 is connected between capacitor 20 and resistor 18. An output of scaling circuit 204 is connected to module 206. Module 206 may be implemented as either an analog-to-digital (A-D) converter or a comparator. If implemented as an A-D converter, module 206 converts a voltage from scaling circuit 204 into a digital signal and provides that signal to microprocessor 12. If implemented as a comparator, module 206 compares the voltage from scaling circuit 204 with a reference voltage and provides an output to microprocessor 12. In this way, microcontroller 12 can monitor the voltage across capacitor 20.

Microcontroller 12 detects a short-circuit fault during test of the over-current circuitry to avoid over-burdening the power supply. Some power supplies have limited current sourcing capability and will therefore shut down if a large current is drawn for a given time period. If a short-circuit fault is present at load 36, for example, a large current will be drawn when high-side switch 14 is enabled which could potentially shut down the power source if the switch is enabled for too long. Because an over-current condition is expected during test, the short-circuit condition will go undetected, creating a large average current draw from the power supply for the duration of the high-side switch 14 enablement procedure. Therefore, monitor circuit 200 is implemented to detect a short-circuit fault in system 10 during test of the over-current detection circuitry and thus limiting the current draw from the power supply to a single high-side switch 14 enable pulse duration.

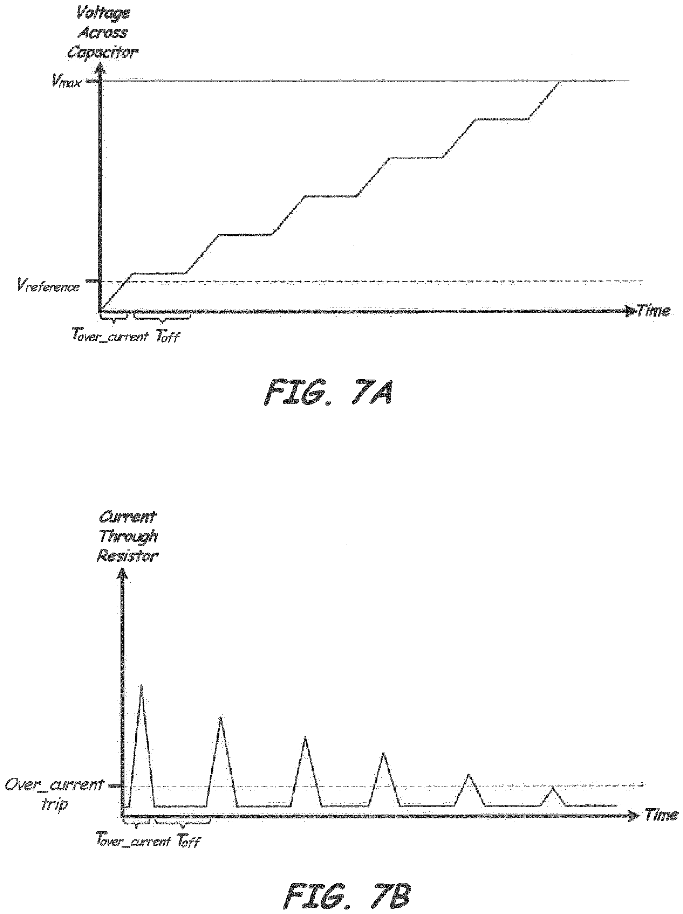

FIGS. 7A and 7B are charts illustrating a voltage across capacitor 20 compared to a reference voltage (V_{reference}), and a current through resistor 18 compared to an over-current trip reference, respectively, according to an embodiment of the present invention. FIGS. 7A and 7B include corresponding time axes. If the voltage across capacitor 20 is less than V_{reference} after high-side switch 14 has been enabled for greater than T_{over-current}, microcontroller 12 will flag a short circuit fault and disable high-side switch 14. If no short-circuit fault is present in system 10, capacitor 20 should charge during the time that high-side switch 14 is enabled, and, as illustrated in FIG. 7B, generate an expected over-current condition based upon the in-rush current through capacitor 20. Therefore, V_{reference} can be selected such that it is less than the voltage capacitor 20 should have charged to following enablement of high-side switch 14 for greater than T_{over-current}, but is greater than the voltage across capacitor 20 if a short circuit fault is preventing capacitor 20 from charging.

Microcontroller 12 monitors the voltage across capacitor 20 in order to ensure that no short circuit fault is present in system 10 during self-test of system 10. After high-side switch 14 has been enabled for greater than T_{over-current}, high-side switch 14 is disabled. Microcontroller 12 waits a short time period and measures the voltage across capacitor 20. If no short-circuit is present, the voltage across capacitor 20 will be greater than the reference voltage. If it is not, microcontroller 12 indicates a short circuit fault and aborts enablement of high-side switch 14. These checks are continued following each enablement of high-side switch 14 during the test of the over-current detection of system 10. The predefined voltage compared to the voltage across capacitor 20 is kept at a constant level because if a short circuit is ever present, the voltage across capacitor 20 will quickly drop below the predefined voltage.

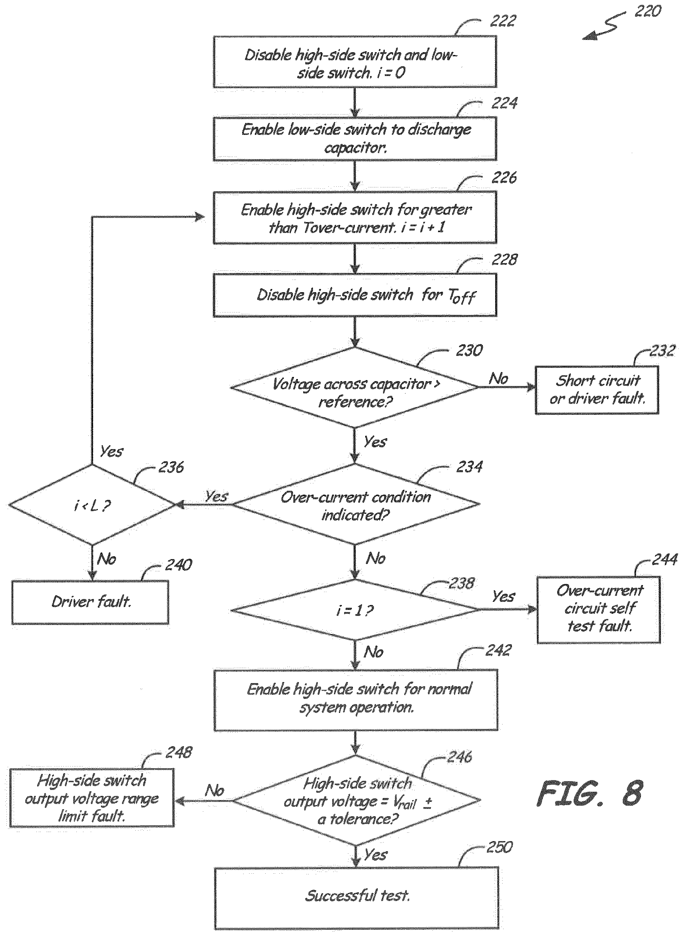

FIG. 8 is a flowchart illustrating a method 220 for testing over-current detection according to a separate embodiment of the present invention. At step 222, high-side switch 14 and low-side switch 16 are disabled. Microcontroller 12 tracks the number of times (i) high-side switch 14 is enabled. At step 224, low-side switch 16 is enabled for a short period of time to discharge capacitor 20. At step 226, high-side switch 14 is enabled for a time greater than T_{over-current} in order to test over-current detection. At step 228, high-side switch 14 is disabled for a time (T_{off}) sufficient to limit the average surge current from power supply input 28 based upon the high-side switch 14 enablement time (T_{over-current}) and the current sourcing capability of power supply 28. At step 230, the voltage across capacitor 20 is compared with a reference voltage (V_{reference}) to determine if a short-circuit fault is present in system 10. If the voltage across capacitor 20 is greater than V_{reference}, method 220 proceeds to step 234. If the voltage across capacitor 20 is less than the V_{reference}, method 220 proceeds to step 232, indicates a fault, and terminates enablement of high-side switch 14. This fault is indicated as a short circuit fault if an over-current condition was indicated by microcontroller 12, and as a driver fault if no over-current condition was indicated. At step 234, it is determined if an over-current fault was indicated by microcontroller 12. If an over-current condition was indicated, method 220 proceeds to step 236. If an over-current condition was not indicated, then the capacitor is charged to a level such that the in-rush current no longer creates an over-current condition and method 220 proceeds to step 238. At step 236, it is determined if high-side switch 14 has been enabled greater than a maximum number of times (L). The maximum number of times (L) is set as a value that ensures that high-side switch 14 has been enabled enough times to charge capacitor 20 to a point that an over-current condition should no longer be indicated. If high-side switch 14 has been enabled greater than the maximum number of times (L), method 220 proceeds to step 240 and indicates a driver fault. If it has not, method 220 returns to step 226. At step 238, it is determined if high-side switch has only been enabled one time. If it has, method 220 proceeds to step 244, an over-current circuit self-test fault is indicated and enablement of high-side switch 14 is aborted. This is due to the fact that an over-current condition should always be indicated during the first enablement of high-side switch 14. If high side switch 14 has been enabled more than once, the method 220 proceeds to step 242 and performs a soft-start method such as those illustrated in FIGS. 4 and 5 in order to complete the charging of capacitor 20. At step 246, the voltage across capacitor 20 is compared, using analog-to-digital converter 206, with the voltage provided on input 28. If the voltage across the capacitor is within a given tolerance of the voltage provided on input 28, method 220 proceeds to step 250 and indicates a successful test. If the voltage is not within the given tolerance, method 220 proceeds to step 248 and indicates a high-side switch output voltage range limit fault.

In this way, the present invention describes an over-current fault detection system that has an ability to self-test the over-current fault detection in the field. Although the present invention has been described with reference to preferred embodiments, workers skilled in the art will recognize that changes may be made in form and detail without departing from the scope of the invention as defined by the claims.

## Claims

1. A system for testing over-current fault detection that includes a load (36) and a capacitor (20) connected in parallel with the load (36), a microcontroller (12), and a first switch (14) to connect a voltage to the load (36) and the capacitor (20), the system comprising:
a first monitor circuit (38) that is configured to monitor a current from the first switch to the load and to the capacitor and to provide a first output to the microcontroller (12), wherein the microcontroller (12) is configured to detect an over-current fault condition based upon the first output; and
a second monitor circuit (200) that is configured to monitor a voltage across the capacitor and to provide a second output to the microcontroller (12);
wherein the microcontroller (12) is further configured to control a state of the first switch to connect voltage to the load; and
wherein the microcontroller is configured to self-test over-current detection of the system based upon current generated during charging of the capacitor using the first output, and wherein the microcontroller is configured to indicate that the self-test failed or was successful, and wherein the microcontroller is configured to detect a short-circuit fault condition during the self-test based upon the second output.

2. The system of claim 1, wherein the second monitor circuit comprises:
a scaling circuit (204) that is configured to scale the voltage across the capacitor; and
an analog-to-digital converter (206) that is configured to convert the scaled voltage from the scaling circuit to a digital signal and provides the digital signal to the microcontroller.

3. The system of claim 2, wherein the second monitor circuit further comprises a limit resistor to limit in-rush current to the capacitor.

4. The system of claim 2, wherein the microcontroller is further configured to compare the digital signal from the analog-to-digital converter with value indicative of a reference voltage and configured to indicate a short-circuit fault if the voltage across the capacitor is less than the reference voltage.

5. The system of claim 1, wherein the second monitor circuit comprises:
a scaling circuit (204) that is configured to scale the voltage across the capacitor; and
a comparator that is configured to compare the scaled voltage from the scaling circuit with a reference voltage; and
wherein the microcontroller is further configured to monitor an output of the comparator to indicate a short circuit is present if the voltage across the capacitor is less than the reference voltage.

6. The system of claim 1, further comprising a second switch (16) configured to connect the load to ground.

7. The system of claim 1, wherein the first monitor circuit is configured to monitor the current from the first switch to the load and to the capacitor by monitoring voltage across a reference resistor.

8. The system of claim 7, wherein the first monitor circuit comprises:
a difference amplifier (32) that is configured to amplify the voltage across the reference resistor; and
a comparator (34) that is configured to compare an output of the difference amplifier with a reference voltage, wherein an output of the comparator indicates when the output of the difference amplifier is greater than the reference voltage.

9. The system of claim 8, wherein the microcontroller is further configured to indicate an over-current fault and disables the first switch after the comparator's output has indicated that the output of the difference amplifier is greater than the reference voltage for greater than a predefined amount of time.

10. The system of claim 1, wherein the microcontroller is further configured to modulate the first switch on and off in order to charge the capacitor without creating an over-current fault condition.

11. A method for testing over-current fault detection for a system (10) that includes a load (36) and a capacitor (20) connected in parallel with the load (36), a microcontroller (12), and a first switch (14) to connect a voltage to the load (36) and the capacitor (20), the method comprising:
a. enabling, during a self-test, a first switch for a predefined time in order to provide voltage to charge a capacitor;
b. monitoring, during the self-test, a current from the first switch to the load and to the capacitor using a first monitor circuit (38) during the self-test, wherein the first monitor circuit provides a first output to the microcontroller (12), and wherein the microcontroller (12) is configured to detect an over-current fault condition based upon the first output;
c. monitoring, during the self-test, a voltage across the capacitor using a second monitor circuit (200), wherein the second monitor circuit (200) provides a second output to the microcontroller (12);
d. indicating, during the self-test, an over-current fault condition if the first output is larger than a specified value for the predefined time; and
e. indicating, during the self-test, a short-circuit fault condition based upon the second output.

12. The method of claim 11, further comprising:
f. repeating steps a-e if an over-current fault condition was indicated in step d, a short circuit fault was not indicated in step e, and steps a-e have not been completed a predefined number of times;
g. indicating that the self-test failed if an over-current fault condition was not indicated and steps a-e have been completed the predefined number of times; and
h. indicating that the self-test was successful if the over-current fault condition was indicated and steps a-e have been completed the predefined number of times.

13. The method of claim 11, wherein monitoring the voltage across the capacitor comprises:
scaling the voltage across the capacitor; and
comparing a scaled voltage to the reference voltage.

14. The method of claim 11, wherein monitoring the current from the first switch using a first monitor circuit comprises:
inputting voltage on each side of a resistor into a difference amplifier, wherein the resistor is connected between the first switch and the capacitor;
comparing an output of the difference amplifier with a reference voltage using a comparator; and
inputting an output of the comparator to a microcontroller.

15. The method of claim 11, wherein the method further comprises enabling a second switch for a short time period to discharge the capacitor prior to performing step a.

## Patentansprüche

1. System zum Testen einer Überstromfehlererkennung, die einen Verbraucher (36) und einen Kondensator (20), der mit dem Verbraucher (36) parallelgeschaltet ist, eine Mikrosteuerung (12) und einen ersten Schalter (14) beinhaltet, um eine Spannung mit dem Verbraucher (36) und dem Kondensator (20) zu verbinden, wobei das System Folgendes umfasst:
eine erste Überwachungsschaltung (38), die konfiguriert ist, um einen Strom von dem ersten Schalter an den Verbraucher und den Kondensator zu überwachen und ein erstes Ausgangssignal für die Mikrosteuerung (12) bereitzustellen, wobei die Mikrosteuerung (12) konfiguriert ist, um einen Überstromfehlerzustand basierend auf dem ersten Ausgangssignal zu erkennen; und
eine zweite Überwachungsschaltung (200), die konfiguriert ist, um eine Spannung an dem Kondensator zu überwachen und ein zweites Ausgangssignal für die Mikrosteuerung (12) bereitzustellen;
wobei die Mikrosteuerung (12) ferner konfiguriert ist, um einen Zustand des ersten Schalters zu steuern, um die Spannung mit dem Verbraucher zu verbinden; und
wobei die Mikrosteuerung konfiguriert ist, um eine Überstromerkennung des Systems basierend auf während des Aufladens des Kondensators erzeugten Stroms unter Verwendung des ersten Ausgangssignals selbst zu testen, und wobei die Mikrosteuerung konfiguriert ist, um anzuzeigen, dass der Selbsttest gescheitert ist oder erfolgreich war, und wobei die Mikrosteuerung konfiguriert ist, um basierend auf dem zweiten Ausgangssignal einen Kurzschlussfehlerzustand während des Selbsttest zu erkennen.

2. System nach Anspruch 1, wobei die zweite Überwachungsschaltung Folgendes umfasst:
eine Skalierungsschaltung (204), die konfiguriert ist, um die Spannung an dem Kondensator zu skalieren; und
einen Analog-Digital-Wandler (206), der konfiguriert ist, um die skalierte Spannung von der Skalierungsschaltung in ein digitales Signal umzuwandeln, und der das digitale Signal für die Mikrosteuerung bereitstellt.

3. System nach Anspruch 2, wobei die zweite Überwachungsschaltung ferner einen Begrenzungswiderstand umfasst, um den Einschaltstrom an den Kondensator zu begrenzen.

4. System nach Anspruch 2, wobei die Mikrosteuerung ferner konfiguriert ist, um das digitale Signal von dem Analog-Digital-Wandler mit einem Wert zu vergleichen, der eine Referenzspannung anzeigt und konfiguriert ist, um einen Kurzschlussfehler anzuzeigen, falls die Spannung an dem Kondensator weniger als die Referenzspannung beträgt.

5. System nach Anspruch 1, wobei die zweite Überwachungsschaltung Folgendes umfasst:
eine Skalierungsschaltung (204), die konfiguriert ist, um die Spannung an dem Kondensator zu skalieren; und
einen Komparator, der konfiguriert ist, um die skalierte Spannung von der Skalierungsschaltung mit einer Referenzspannung zu vergleichen; und
wobei die Mikrosteuerung ferner konfiguriert ist, um ein Ausgangssignal des Komparators zu überwachen, um anzuzeigen, dass ein Kurzschluss vorhanden ist, falls die Spannung an dem Kondensator weniger als die Referenzspannung beträgt.

6. System nach Anspruch 1, wobei ferner ein zweiter Schalter (16) umfasst ist, der konfiguriert ist, um den Verbraucher mit der Masse zu verbinden.

7. System nach Anspruch 1, wobei die erste Überwachungsschaltung konfiguriert ist, um den Strom von dem ersten Schalter an den Verbraucher und an den Kondensator durch Überwachen der Spannung an einem Referenzwiderstand zu überwachen.

8. System nach Anspruch 7, wobei die erste Überwachungsschaltung Folgendes umfasst:
einen Differenzverstärker (32), der konfiguriert ist, um die Spannung an dem Referenzwiderstand zu verstärken; und
einen Komparator (34), der konfiguriert ist, um ein Ausgangssignal des Differenzverstärkers mit einer Referenzspannung zu vergleichen, wobei ein Ausgangssignal des Komparators anzeigt, wann das Ausgangssignal des Differenzverstärkers größer als die Referenzspannung ist.

9. System nach Anspruch 8, wobei die Mikrosteuerung ferner konfiguriert ist, um einen Überstromfehler anzuzeigen, und den ersten Schalter deaktiviert, nachdem das Ausgangssignal des Komparators anzeigt hat, dass das Ausgangssignal des Differenzverstärkers für länger als ein vorbestimmter Zeitraum größer als die Referenzspannung ist.

10. System nach Anspruch 1, wobei die Mikrosteuerung ferner konfiguriert ist, um das Ein und Aus des ersten Schalters zu modulieren, um den Kondensator aufzuladen, ohne einen Überstromfehlerzustand zu schaffen.

11. Verfahren zum Testen einer Überstromfehlererkennung für ein System (10), das einen Verbraucher (36) und einen Kondensator (20), der mit dem Verbraucher (36) parallelgeschaltet ist, eine Mikrosteuerung (12) und einen ersten Schalter (14) beinhaltet, um eine Spannung mit dem Verbraucher (36) und dem Kondensator (20) zu verbinden, wobei das Verfahren Folgendes umfasst:
a. Aktivieren, während eines Selbsttests, eines ersten Schalters für eine vorbestimmte Zeit, um Spannung zum Aufladen eines Kondensators bereitzustellen;
b. Überwachen, durch den Selbsttest, eines Stroms von dem ersten Schalter an den Verbraucher und an den Kondensator unter Verwendung einer ersten Überwachungsschaltung (38) während des Selbsttests, wobei die erste Überwachungsschaltung ein erstes Ausgangssignal für die Mikrosteuerung (12) bereitstellt, und wobei die Mikrosteuerung (12) konfiguriert ist, um basierend auf dem ersten Ausgangssignal einen Überstromfehlerzustand zu erkennen;
c. Überwachen, während des Selbsttests, einer Spannung an dem Kondensator unter Verwendung einer zweiten Überwachungsschaltung (200), wobei die zweite Überwachungsschaltung (200) ein zweites Ausgangssignal für die Mikrosteuerung (12) bereitstellt;
d. Anzeigen, während des Selbsttests, eines Überstromfehlerzustands, falls das erste Ausgangssignal größer ist als ein spezifischer Wert für die vorbestimmte Zeit; und
e. Anzeigen, während des Selbsttests, eines Kurzschlussfehlerzustands basierend auf dem zweiten Ausgangssignal.

12. Verfahren nach Anspruch 11, wobei ferner Folgendes umfasst ist:
f. Wiederholen der Schritte a-f, falls in Schritt d ein Überstromfehlerzustand angezeigt wurde, in Schritt e kein Kurzschlussfehler angezeigt wurde und die Schritte a-e nicht eine vorbestimmte Anzahl von Malen abgeschlossen worden sind;
g. Anzeigen, dass der Selbsttest gescheitert ist, falls kein Überstromfehlerzustand angezeigt wurde und die Schritte a-e nicht die vorbestimmte Anzahl von Malen abgeschlossen worden sind; und
h. Anzeigen, dass der Selbsttest erfolgreich war, falls der Überstromfehlerzustand angezeigt wurde und die Schritte a-e die vorbestimmte Anzahl von Malen abgeschlossen worden sind.

13. Verfahren nach Anspruch 11, wobei das Überwachen der Spannung an dem Kondensator Folgendes umfasst:
Skalieren der Spannung an dem Kondensator; und
Vergleichen einer skalierten Spannung mit der Referenzspannung.

14. Verfahren nach Anspruch 11, wobei das Überwachen des Stroms von dem ersten Schalter unter Verwendung einer ersten Überwachungsschaltung Folgendes umfasst:
Eingeben von Spannung an jeder Seite eines Widerstands in einen Differenzverstärker, wobei der Widerstand zwischen dem ersten Schalter und dem Kondensator verbunden ist;
Vergleichen eines Ausgangssignals des Differenzverstärkers mit einer Referenzspannung unter Verwendung eines Komparators; und
Eingeben eines Ausgangssignals des Komparators an eine Mikrosteuerung.

15. Verfahren nach Anspruch 11, wobei das Verfahren ferner das Aktivieren eines zweiten Schalters für einen kurzen Zeitraum umfasst, um den Kondensator zu entladen, bevor Schritt a durchgeführt wird.

## Revendications

1. Système de test d'une détection de défaut de surintensité qui comprend une charge (36) et un condensateur (20) connectés en parallèle avec la charge (36), un microcontrôleur (12) et un premier commutateur (14) pour connecter une tension à la charge (36) et au condensateur (20), le système comprenant :
un premier circuit de surveillance (38) qui est configuré pour surveiller un courant du premier commutateur vers la charge et vers le condensateur et pour fournir une première sortie au microcontrôleur (12), dans lequel le microcontrôleur (12) est configuré pour détecter une condition de défaut de surintensité sur la base de la première sortie ; et
un deuxième circuit de surveillance (200) qui est configuré pour surveiller une tension aux bornes du condensateur et pour fournir une deuxième sortie au microcontrôleur (12) ;
dans lequel le microcontrôleur (12) est configuré en outre pour commander un état du premier commutateur pour connecter une tension à la charge ; et
dans lequel le microcontrôleur est configuré pour effectuer un autotest de détection de surintensité du système sur la base d'un courant généré durant la charge du condensateur en utilisant la première sortie, et dans lequel le microcontrôleur est configuré pour indiquer que l'autotest a échoué ou a réussit, et dans lequel le microcontrôleur est configuré pour détecter une condition de défaut de court-circuit durant l'autotest sur la base de la deuxième sortie.

2. Système selon la revendication 1, dans lequel le deuxième circuit de surveillance comprend :
un circuit de mise à l'échelle (204) qui est configuré pour mettre à l'échelle la tension aux bornes du condensateur ; et un convertisseur analogique-numérique (206) qui est configuré pour convertir la tension mise à l'échelle provenant du circuit de mise à l'échelle en un signal numérique et fournit le signal numérique au microcontrôleur.

3. Système selon la revendication 2, dans lequel le deuxième circuit de surveillance comprend en outre une résistance de limitation pour limiter un courant d'appel vers le condensateur.

4. Système selon la revendication 2, dans lequel le microcontrôleur est configuré en outre pour comparer le signal numérique provenant du convertisseur analogique-numérique à une valeur indicative d'une tension de référence et configuré pour indiquer un défaut de court-circuit si la tension aux bornes du condensateur est inférieure à la tension de référence.

5. Système selon la revendication 1, dans lequel le deuxième circuit de surveillance comprend :
un circuit de mise à l'échelle (204) qui est configuré pour mettre à l'échelle la tension aux bornes du condensateur ; et
un comparateur qui est configuré pour comparer la tension mise à l'échelle provenant du circuit de mise à l'échelle à une tension de référence ; et
dans lequel le microcontrôleur est configuré en outre pour surveiller une sortie du comparateur pour indiquer qu'un court-circuit est présent si la tension aux bornes du condensateur est inférieure à la tension de référence.

6. Système selon la revendication 1, comprenant en outre un deuxième commutateur (16) configuré pour connecter la charge à la terre.

7. Système selon la revendication 1, dans lequel le premier circuit de surveillance est configuré pour surveiller le courant du premier commutateur vers la charge et vers le condensateur en surveillant une tension aux bornes d'une résistance de référence.

8. Système selon la revendication 7, dans lequel le premier circuit de surveillance comprend :
un amplificateur de différence (32) qui est configuré pour amplifier la tension aux bornes de la résistance de référence ; et
un comparateur (34) qui est configuré pour comparer une sortie de l'amplificateur de différence à une tension de référence, dans lequel une sortie du comparateur indique quand la sortie de l'amplificateur de différence est supérieure à la tension de référence.

9. Système selon la revendication 8, dans lequel le microcontrôleur est configuré en outre pour indiquer un défaut de surintensité et désactiver le premier commutateur après que la sortie du comparateur a indiqué que la sortie de l'amplificateur de différence est supérieure à la tension de référence pendant plus qu'une quantité de temps prédéfinie.

10. Système selon la revendication 1, dans lequel le microcontrôleur est configuré en outre pour moduler le premier commutateur en marche et arrêt de manière à charger le condensateur sans créer une condition de défaut de surintensité.

11. Procédé de test d'une détection de défaut de surintensité pour un système (10) qui comprend une charge (36) et un condensateur (20) connectés en parallèle avec la charge (36), un microcontrôleur (12) et un premier commutateur (14) pour connecter une tension à la charge (36) et au condensateur (20), le procédé comprenant :
a. l'activation, durant un autotest, d'un premier commutateur pendant un temps prédéfini de manière à fournir une tension pour charger un condensateur ;
b. la surveillance, durant l'autotest, d'un courant du premier commutateur vers la charge et vers le condensateur en utilisant un premier circuit de surveillance (38) durant l'autotest, dans lequel le premier circuit de surveillance fournit une première sortie au microcontrôleur (12), et dans lequel le microcontrôleur (12) est configuré pour détecter une condition de défaut de surintensité sur la base de la première sortie ;
c. la surveillance, durant l'autotest, d'une tension aux bornes du condensateur en utilisant un deuxième circuit de surveillance (200), dans lequel le deuxième circuit de surveillance (200) fournit une deuxième sortie au microcontrôleur (12) ;
d. l'indication, durant l'autotest, d'une condition de défaut de surintensité si la première sortie est supérieure à une valeur spécifiée pendant le temps prédéfini ; et
e. l'indication, durant l'autotest, d'une condition de défaut de court-circuit sur la base de la deuxième sortie.

12. Procédé selon la revendication 11, comprenant en outre :
f. la répétition des étapes a-e si une condition de défaut de surintensité a été indiquée dans l'étape d, un défaut de court-circuit n'a pas été indiqué dans l'étape e, et les étapes a-e n'ont pas été complétées un nombre de fois prédéfini ;
g. l'indication que l'autotest a échoué si une condition de défaut de surintensité n'a pas été indiquée et les étapes a-e ont été complétées le nombre de fois prédéfini ; et
h. l'indication que l'autotest a réussi si la condition de défaut de surintensité a été indiquée et les étapes a-e ont été complétées le nombre de fois prédéfini.

13. Procédé selon la revendication 11, dans lequel la surveillance de la tension aux bornes du condensateur comprend :
la mise à l'échelle de la tension aux bornes du condensateur ; et
la comparaison d'une tension mise à l'échelle à la tension de référence.

14. Procédé selon la revendication 11, dans lequel la surveillance du courant provenant du premier commutateur en utilisant un premier circuit de surveillance comprend :
l'application en entrée d'une tension sur chaque côté d'une résistance dans un amplificateur de différence, dans lequel la résistance est connectée entre le premier commutateur et le condensateur ;
la comparaison d'une sortie de l'amplificateur de différence à une tension de référence en utilisant un comparateur ; et
l'application en entrée d'une sortie du comparateur à un microcontrôleur.

15. Procédé selon la revendication 11, dans lequel le procédé comprend en outre l'activation d'un deuxième commutateur pendant une courte période de temps pour décharger le condensateur avant l'exécution de l'étape a.
